# EUROPEAN PATENT APPLICATION

(11) **EP 2 595 200 A2**
(43) Date of publication of application: **22.05.2013**
(21) Application number: 12192906.1
(22) Date of filing: 16.11.2012
(51) Int. Cl.: H01L 31/048, H01L 31/052

(54) **Solar cell module and light control sheet for solar cell module**

(30) Priority: 18.11.2011 JP 2011252997
(71) Applicant: Shin-Etsu Chemical Co., Ltd., Chiyoda-ku Tokyo (JP)
(72) Inventor: Firihata, Tomoyoshi, Annaka-shi, Gunma (JP); Ito, Atsuo, Annaka-shi, Gunma (JP); Kim, Hyung Bae, Annaka-shi, Gunma (JP); Igarashi, Minoru, Annaka-shi, Gunma (JP); Hotta, Masakatsu, Annaka-shi, Gunma (JP); Nakamura, Tsutomu, Annaka-shi, Gunma (JP)
(74) Representative: Ter Meer Steinmeister & Partner

(57) **Abstract**

A solar cell module is composed of a panel of transparent material that transmits sunlight, a panel of heat-conducting material arranged opposite to the sunlight incidence side, a light transmitting elastomer member, and a solar cell element, the light transmitting elastomer member and the solar cell element being interposed between the panel of transparent material and the panel of heat-conducting material, with the light transmitting elastomer member being disposed on the sunlight incidence side, in such a way that the light-transmitting elastomer member presses the solar cell element against the panel of heat-conducting material. By altering the optical path of the direct incident light with the refractive action of the light transmitting elastomer, the solar cell module allows the finger electrodes and/or bus bar electrodes of the solar cell element to be placed in the region where there is less incident sunlight than the region where there is direct incident sunlight not affected by refractive action.

The solar cell module of the present invention has a high conversion efficiency and exhibits good durability during prolonged outdoor exposure. Therefore, it is useful for photovoltaic power plants of large scale which play an important role as the energy source to solve the global environment issue.

## Description

### TECHNICAL FIELD

The present invention relates to a solar cell module and a light control sheet for the solar cell module.

### BACKGROUND ART

Photovoltaic power generation is attracting great attention because of its potential as an important energy source that will solve the global environmental issue. It relies mostly on solar cells of crystalline silicon which function as photoelectric converters. Continued research and development have been made to improve their photoelectric conversion efficiency. Such efforts have come to fruition in the contrivance of, in the field of solar cells of monocrystalline silicon, new solar cells with the heterojunction layer of amorphous silicon having a large band gap, or new solar cells of back contact type which obviate the necessity of the collecting electrode layer on the light incidence plane, thereby minimizing the loss of incident light by the electrodes on the light incidence plane. Such new solar cells have achieved a photoelectric conversion efficiency higher than 20%.

The solar system for photovoltaic power generation includes solar cell modules for conversion of sunlight into electricity, cables for connecting the converted electricity to transmission networks, and peripheral equipment. The solar cell modules are required to have very good durability because they are exposed to sunlight outdoors. According to the "Road map for photovoltaic power generation (PV2030+)" settled in 2009 by New Energy and Industrial Technology Development Organization (an independent administrative agency), the life of solar cells will be 25 years in 2017 and 30 years in 2025. For photovoltaic power generation to be a basic electric power source comparable with thermal power, nuclear power, and hydraulic power which dominate in commercial power supply, it is necessary to realize highly durable solar cells ahead of the development plan.

Conventional solar cell modules include solar cells of crystalline silicon which have both sides sealed with EVA (ethylene-vinyl acetate copolymer) for improved reliability. Unfortunately, EVA has a disadvantage of becoming soft at high temperatures and hard at low temperatures owing to its low glass transition point. In other words, it expands and shrinks in response to temperature change in the outdoor environment, and this causes defective wiring in solar cells of crystalline silicon. Thus, usage of EVA is a hindrance to extending the life of solar cell modules beyond 25 years.

EVA also has another disadvantage of requiring laminating process for sealing that involves heating and evacuation. The process includes a lot of complex steps. Any inadequacies in laminating process impair the characteristic properties of solar cells. There have been proposed two ways to address this problem. One is by applying a heat-resistant film to the lead wires which extend from the anode and cathode at both ends of the solar cell module, thereby protecting the lead wires from shorting with other lead wires (as disclosed in Patent Document 1: JP-A 1997-326497). The other is by coating at least either of the front and back of each photovoltaic power element with a laminate film composed of at least two kinds of resin, thereby improving yields (as disclosed in Patent Document 2: JP-A 1999-87744).

The solar cell modules installed outdoors get very hot especially in summer, and so do solar cell elements therein. It is known that they decrease in power generating efficiency as they increase in temperature. For example, in the case of monocrystalline silicon cells, the decrease is about 0.4% per degree of the element temperature of increase from 25°C (at which the efficiency is assumed to be 100%). Thus, how the rising temperature of the solar cell elements is dispersed is an important factor for efficient operation of solar cell modules.

Various contrivances have been made for efficient heat dissipation in order to suppress the temperature rise of solar cells. They include, for example, a radiator of highly heat-conductive metal attached to the back of the solar cell module (Patent Document 3: JP 2770906), a combination of heat-conductive block members and heat pipes to release heat from the reverse (Patent Document 4: JP-A 1997-186353), a heat radiator of laminate structure composed of metals differing in linear expansion coefficient (Patent Document 5: JP 4206265), and a metallic member in long sheet form bonded to the reverse for heat dissipation (Patent Document 6: JP-A 2006-156581). The metallic materials used for heat dissipation are economically unfavorable for the solar cell modules because of their high material cost and processing cost. In addition, they add to the weight of modules, thereby making their handling inconvenient.

Unlike conventional solar cells of monocrystalline silicon, solar cells of HIT type or back contact type, which achieve the conversion efficiency higher than 20%, need special apparatus or equipment for deposition of amorphous silicon layers and forming fine electrodes. This leads to a high production cost of solar cells and prevents the spread of solar cells. Thus, there has been a demand for a new technology to improve conversion efficiency by reducing the loss of incident light caused by the collecting electrodes on the light incidence plane with low cost.

The conventional technology presents difficulties in efficient heat dissipation from heated solar cell elements on account of strains resulting from difference in linear expansion coefficient between the solar cell element and the material for heat radiation where temperature rises. This holds true particularly in the case of solar cell elements fabricated from a silicon wafer up to 200 µm. Such solar cell elements undergoing temperature increase are subject to cracking due to difference in linear expansion coefficient between the solar cell element and the material in close contact therewith. It is known that EVA in general use as a sealing material greatly changes in modulus due to temperature change (for example, Non-Patent Document 1: Barry Ketola, Keith R. McIntosh, Ann Norris, Mary Kay Tomalia, "Silicone For Photovoltaic Encapsulation," 23rd European Photovoltaic Solar Energy Conference 2008, pp. 2969-2973), and such defects would adversely affect solar cell elements.

For reduction in production cost of solar cell modules, there is a strong demand for cost reduction of silicon wafers, because the cost of silicon wafers accounts for at least 50% of that of solar cell modules. One way to meet this demand for the solar cell element excellent in terms of cost performance is not only by reducing the area of solar cells but also by reducing the thickness of solar cells to up to 120 µm. Unfortunately, solar cell elements fabricated from such thin silicon wafers are vulnerable to shocks, and hence they are not compatible with the sealing and heat radiating materials used for solar cell elements fabricated from silicon wafers thicker than 200 µm. It has been pointed out that the connection of wiring on the surface of solar cell elements is subject to degradation in the outdoor environment where temperature rises and lowers continually, on account of difference in modulus and linear expansion coefficient between the sealing materials on the front and back of solar cell elements (Non-Patent Documents 2 and 3: D. L. King, M. A. Quintana, J. A.Kratochvil, D. E. Ellibee and B. R. Hansen, "Photovoltaic Module Performance and Durability Following Long Term Field Exposure, Progress in Photovoltaics," Research and Application 8 (2000) pp. 241-256, and M. A. Quintana, D. L. King, T. J. MacMahon and C. R. Osterwald, "Commonly Observed Degradation in Field-Aged Photovoltaic Modules," Proceedings of the 29th IEEE Photovoltaic Specialists Conference, New Orleans, (2002) pp. 1436-1439).

The conventional technology suffers another disadvantage costwise because it needs an adhesive to bond the solar cell element to the heat radiating member or it needs two kinds of resin layers for efficient heat dissipation. These additional parts add to production cost. Particularly, the adhesive is also liable to degradation as mentioned above, which results in foreign matter, after use for at least 10 years in the outdoor environment where temperature rises and falls continually.

Moreover, the conventional technology is poor in yield rate because it needs the covering of lead wires with a film or the covering material in the form of laminate film composed of at least two kinds of resin. This structure adds to production cost and prevents easy reworking.

### Citation List

Patent Document 1: JP-A 1997-326497
Patent Document 2: JP-A 1999-87744
Patent Document 3: JP 2770906
Patent Document 4: JP-A 1997-186353
Patent Document 5: JP 4206265
Patent Document 6: JP-A 2006-156581
Non-Patent Document 1: Barry Ketola, Keith R. McIntosh, Ann Norris, Mary Kay Tomalia, "Silicone For Photovoltaic Encapsulation," 23rd European Photovoltaic Solar Energy Conference 2008, pp. 2969-2973.
Non-Patent Document 2: D. L. King, M. A. Quintana, J. A. Kratochvil, D. E. Ellibee and B. R. Hansen, "Photovoltaic Module Performance and Durability Following Long Term Field Exposure, Progress in Photovoltaics," Research and Application 8 (2000) pp. 241-256.
Non-Patent Document 3: M. A. Quintana, D. L. King, T. J. MacMahon and C. R. Osterwald, "Commonly Observed Degradation in Field-Aged Photovoltaic Modules," Proceedings of the 29th IEEE Photovoltaic Specialists Conference, New Orleans, (2002) pp. 1436-1439.

### SUMMARY OF INVENTION

### Technical Problem

It is an object of the present invention to provide a solar cell module having a high conversion efficiency and a light control sheet for the solar cell module.

### Solution to Problem

In order to address the above problems, the present inventors carried out a series of researches, which led to the finding that a solar cell module composed of solar cell elements each having a semiconductor substrate held in a space between a panel of transparent material that transmits incident sunlight and a panel of heat-conductive material opposite to the sunlight incidence plane, with the solar cell elements sealed under pressure by a light-transmitting elastomeric material having rubbery resilience, exhibits a high conversion efficiency if it has its light incidence plane coated with the light-transmitting elastomer material in such a way that it alters the direct incident light by its refractive action and also if the solar cell has its finger electrodes and/or bus bar electrodes of the solar cell element arranged in the region where there is less incident light than the region where there is direct incident light not affected by refractive action. The solar cell module constructed as mentioned above obviates the necessity of forming fine electrodes by photolithography and forming heterojunction layers, and it also minimizes the loss of incident sunlight due to collecting electrodes on the light incidence plane, thereby exhibiting a high conversion efficiency. Moreover, the solar cell module is very little vulnerable to degradation due to shrinkage of EVA that occurs as it changes in temperature during its outdoor exposure. Finally, the solar cell module is provided with a light control sheet which seals the solar cell module and minimizes the loss of light due to collecting electrodes arranged on its light incidence plane. The present invention is based on the finding mentioned above.

The present invention provides a solar cell module and a light control sheet for solar cell module, which are defined in the following.
[1] A solar cell module composed of a panel of transparent material that transmits sunlight, a panel of heat-conducting material arranged opposite to the sunlight incidence side, a light transmitting elastomer member, and a solar cell element, the light transmitting elastomer member and the solar cell element being interposed between the panel of transparent material and the panel of heat-conducting material, with the light transmitting elastomer member being disposed on the sunlight incidence side, in such a way that the light-transmitting elastomer member presses the solar cell element against the panel of heat-conducting material, wherein the light transmitting elastomer member includes a plurality of small pieces joined together, at least whose light incidence plane has a semicircular cross section, semielliptic cross section, or half-racetrack-like cross section with round sides, and the small pieces are formed such that the finger electrodes and/or bus bar electrodes of the solar cell element are arranged at the joining parts of the small pieces so that the light transmitting elastomer member alters the optical path of the direct incident light by the refractive action of the light transmitting elastomer, thereby allowing the finger electrodes and/or bus bar electrodes of the solar cell element to be placed in the region where there is less incident light than the region where there is direct incident light not affected by refractive action.
[2] The solar cell module of paragraph [1], wherein the panel of heat conductive material and the solar cell element are arranged with heat conductive elastomer layer interposed between them.
[3] The solar cell module of paragraph [2], wherein the heat conductive elastomer layer is formed from heat-conductive silicone rubber having a thermal conductivity at least 0.2 W/m·K and up to 5 W/m·K.
[4] The solar cell module of any one of paragraphs [1] to [3], wherein the panel of transparent material and the panel of heat conductive material are arranged such that a spacer member is placed at the end of the space between the panels.
[5] The solar cell module of any one of paragraphs [1] to [4], wherein the panel of transparent material and the panel of heat conductive material are fixed together by a frame member which is spanned between the panels' peripheries.
[6] The solar cell module of any one of paragraphs [1] to [5], wherein the panel of heat conductive material is formed from glass, synthetic resin, or metal, or composite material thereof.
[7] The solar cell module of any one of paragraphs [1] to [6], wherein the solar cell element is formed from silicon material.
[8] The solar cell module of any one of paragraphs [1] to [7], wherein the light-transmitting elastomer member is a cured product of silicone rubber composition.
[9] A light control sheet for solar cell modules which is arranged on the light incidence side of a solar cell element having finger electrodes and bus bar electrodes and which disperses the direct incident light entering the finger electrodes and/or bus bar electrodes toward the surrounding thereof, wherein the finger electrodes and/or bus bar electrodes of the solar cell element are arranged at joining parts of a plurality of small pieces of elastomer joined together, at least whose light incidence plane has a semicircular cross section, semielliptic cross section, or half-racetrack-like cross section with round sides.

### Advantageous Effects of Invention

The solar cell module according to the present invention has a high conversion efficiency and exhibits good durability during prolonged outdoor exposure. Therefore, it is useful for photovoltaic power plants of large scale which play an important role as the energy source to solve the global environment issue.

In addition, the solar cell module obviates the necessity of sealing solar cell elements by complex laminating process. This leads to higher yields, and the solar cell elements are capable of easy reworking because they are simply fitted under pressure by an elastomeric material. This facilitates replacement of solar cells when any malfunction occurs in the solar cell module, and this permits the reuse of the constituents of the solar cell module.

### BRIEF DESCRIPTION OF DRAWINGS

Fig. 1 is a sectional view showing one example of the solar cell module;
Fig. 2 is a schematic diagram showing the sunlight (normal to the sunlight incidence plane) impinging on the light-transmitting elastomer member (or the light control sheet); and
Fig. 3 is a schematic diagram showing the sunlight (inclined 50 degrees with respect to the sunlight incidence plane) impinging on the light-transmitting elastomer member (or the light control sheet).

### DESCRIPTION OF EMBODIMENTS

The following is a description of an illustrated solar cell module according to one preferred embodiment of the present invention.

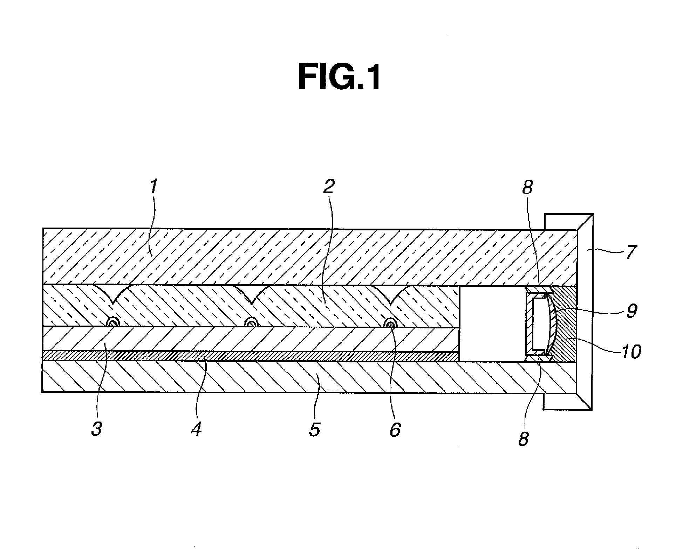

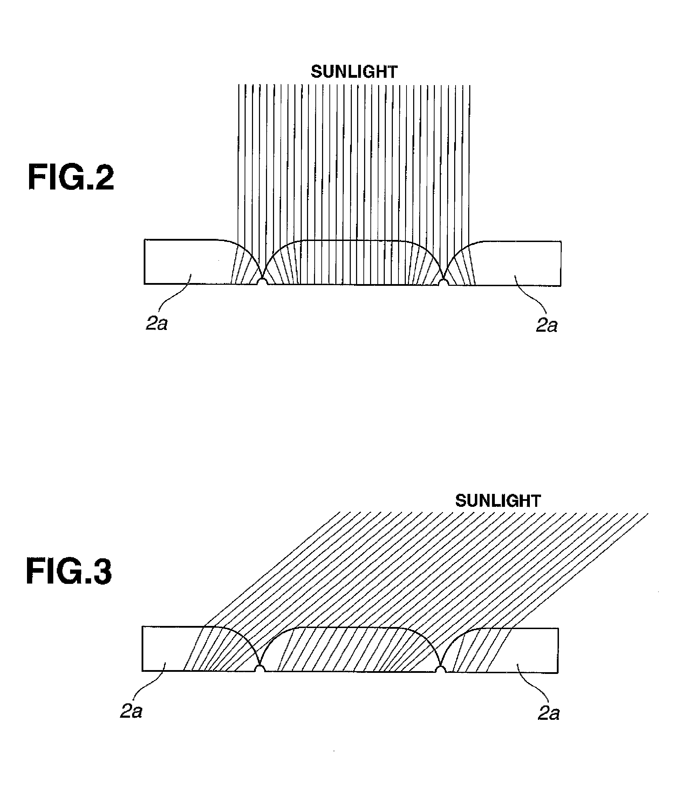

Fig. 1 is a sectional view showing one example of the solar cell module in which a flat sheet is used as a light-transmitting elastomer member. Fig. 2 is a schematic diagram showing a sunlight impinging on the light-transmitting elastomer member (or the light control sheet). The sunlight in Fig. 2 is normal to the sunlight incidence plane. Fig. 3 is also a schematic diagram showing the sunlight impinging on the light-transmitting elastomer member (or the light control sheet). The sunlight in Fig. 3 is inclined 50 degrees with respect to the sunlight incidence plane.

In Fig. 1, there are shown a light-transmitting material panel 1 through which sunlight enters, a heat-conducting material panel 5 placed opposite to the sunlight incidence plane. In a gap between the panels 1 and 5, a light-emitting elastomer material 2 and a solar cell element 3 composed of a semiconductor substrate are placed, with the light-emitting elastomer material 2 being adjacent to the sunlight incidence plane and the solar cell element 3 being fixed under pressure to the heat-conducting material panel 5. The solar cell element 3 having finger electrodes or bus bar electrodes 6 is interposed between the light-emitting elastomer material 2 and the heat-conducting material panel 5.

There is a heat-conducting elastomer layer 4 between the solar cell element 3 and the heat-conducting material panel 5. And the solar cell element 3, which has the finger electrodes or bus bar electrodes 6, is fixed under pressure to the heat-conducting material panel 5, with the heat-conducting elastomer layer 4 interposed between them.

According to the embodiment shown in Fig. 1, the solar cell elements 3 are closely arranged side by side, and the light-transmitting elastomer member 2 is shaped in a flat sheet as a whole.

The light-transmitting elastomer member 2 is formed such that it functions as a light control sheet, at least whose light incidence plane has a semicircular cross section, semielliptic cross section, or half-racetrack-like cross section with round sides. The light control sheet should preferably be composed of elastomer small pieces 2a, each having the semicircular cross section, semielliptic cross section, or half-racetrack-like cross section and round sides, arranged side by side. The light-transmitting elastomer member 2 or the solar cell elements 3 are arranged such that the finger electrodes and/or bus bar electrodes 6 of the solar cell element 3 are positioned at the place where the elastomer small pieces 2a join together. This structure causes the incident sunlight (or direct incident light) to refract at at least both sides of the light-transmitting elastomer member (or the light control sheet) 2. The result of such refraction or the change in optical path of the direct incident light is that the amount of direct incident sunlight reaching the finger electrodes and/or bus bar electrodes 6 at the joining parts is less than that at the other parts on the surface of the solar cell element.

Fig. 2 is a schematic diagram showing how the incident sunlight enters the light-transmitting elastomer member (light control sheet) 2 in the direction normal to the sunlight incidence plane. It is to be noted from this figure that the light-transmitting elastomer member 2 prevents the loss of sunlight due to the shadows of the finger electrodes and/or bus bar electrodes 6 because of its refracting action. In other words, the light-transmitting elastomer member 2 refracts the path of the incident sunlight, especially the direct light which originally enters straight to the electrodes, toward the vicinity of the electrodes, and disperses the light. This helps reduce the so-called shadow loss.

Fig. 3 is a schematic diagram showing how the incident sunlight enters the light-transmitting elastomer member (light control sheet) 2 in the direction aslant 50 degrees to the sunlight incidence plane. It is to be noted that, as shown in Fig. 2, Fig. 3 shows that the light-transmitting elastomer member 2 refracts the path of the incident sunlight, especially the direct light which originally enters straight to the electrodes, toward the vicinity of the electrodes, and disperses the light, thereby reducing the shadow loss.

The panels 1 and 5 mentioned above are arranged, with a spacer 9 interposed between them, which is placed near the end of the space between them. The spacer 9 is fixed to the panels 1 and 5, with sealing compounds 8 filling the gap between the upper part of the spacer 9 and the panel 1 and the gap between the lower part of the spacer 9 and the panel 5. The spacer 9 is also fixed by a sealing compound 10 that fills the end position of the gap between the panels 1 and 5. There are arranged the light-transmitting elastomer member 2, the solar cell element 3 having the finger electrodes or bus bars 6 formed thereon, and the heat-conducting elastomer material layer 4, which are tightly sealed in the space between the panels 1 and 5. The panels 1 and 5 are fastened in position by a rectangular C-shaped frame member 7 engaged with their ends.

The panel 1, which is a member of light-transmitting material, should be made of any material having good transparency, weather resistance, and shock resistance, which ensures high reliability during prolonged outdoor use. Examples of such material include white tempered sheet glass, acrylic resin, fluoroplastic, and polycarbonate resin. A common one among them is white tempered sheet glass having a thickness of about 3 to 5 mm.

The heat-conducting material panel 5 should be made of glass, synthetic resin, metal, or composite material thereof, so that it efficiently dissipates heat out of the solar cell element. Examples of glass include blue sheet glass, white sheet glass, and tempered glass. Examples of synthetic resin include acrylic resin, polycarbonate (PC) resin, polyethylene terephthalate (PET) resin and epoxy resin. Examples of metal include copper, aluminum, and iron. Examples of composite material include synthetic resin uniformly incorporated with a highly heat-conductive material such as silica, titanium oxide, aluminum, and aluminum nitride.

The heat-conducting material panel 5 and the heat-conductive elastomer layer 4 should preferably be transparent ones, so that the solar cell module permits part of the direct sunlight or scattered sunlight impinging thereon to pass through, thereby shining its shadow. When the solar cell module is set in a pasture, the function helps to shine light into the land shaded by the solar cell module, thereby growing green, which helps to use the land for grazing.

The solar cell element 3 should be made of either or both of single-crystalline silicon and polycrystalline silicon.

The light-transmitting elastomer member 2 mentioned above will be described below. It is a sheet formed by curing from a silicone rubber composition of millable type highly filled with fumed silica. This cured product, i.e., the silicone rubber, should have high clarity, good weatherability (or resistance to ultraviolet light), and long-term reliability in outdoor use for at least 20 years, which are required of the solar cell module. Moreover, the silicone rubber composition should be capable of molding in various ways, such as thermal compression molding, extrusion molding, and calendering, which are suitable for efficient mass production of optical sheets for concentrating solar cells.

The above-mentioned sheet of the silicone rubber is obtained by curing a silicone rubber composition which comprises:
(A) 100 parts by weight of an organopolysiloxane which is represented by the average compositional formula (I) below,

   R¹ₐSiO_{(4-a)/2} (I)

   wherein R¹ is identical or different and an unsubstituted or substituted monovalent hydrocarbon group, and letter a is a positive number from 1.95 to 2.05;
   and which has at least two aliphatic unsaturated groups in one molecule and also has a degree of polymerization at least 100;
(B) 70 to 150 parts by weight of fumed silica having a specific surface area larger than 200 m²/g;
(C) 0.1 to 30 parts by weight of an organohydrogenpolysiloxane which contains in one molecule at least two hydrogen atoms bonded to silicon atoms; and
(D) a catalytic amount of a catalyst for hydrosilylizing reaction.

This silicone rubber composition is a millable type capable of extrusion molding and calendaring. It gives rise to a cured product which has a high degree of transparency despite silica contained therein and hence which is suitable for the optical sheet of solar cells of concentration type.

Component (A) is an organopolysiloxane having a degree of polymerization at least 100, which is represented by the average compositional formula (I) above. In the average compositional formula (I), R¹ is identical or different and an unsubstituted or substituted monovalent hydrocarbon group. It is usually one having 1 to 12 carbon atoms, preferably 1 to 8 carbon atoms. Its typical examples include: alkyl groups such as methyl group, ethyl group, propyl group, butyl group, hexyl group, and octyl group; cycloalkyl groups such as cyclopentyl group and cyclohexyl group; alkenyl groups such as vinyl group, allyl group, and propenyl group; cycloalkenyl groups; aryl groups such as phenyl group, and tolyl group; aralkyl groups such as benzyl group and 2-phenylethyl group; and any one of the above groups having the hydrogen atoms therein partly or entirely substituted by halogen atoms or cyano groups. Of these examples, methyl group, vinyl group, phenyl group, and trifluoropropyl group are preferable, and methyl group and vinyl group are particularly preferable.

Typical examples of component (A) include an organopolysiloxane whose main chain is composed of repeating units consisting of dimethylsiloxane unit, or the combination of dimethylsiloxane unit and any one of diphenylsiloxane unit, methylphenylsiloxane unit, methylvinylsiloxane unit and methyl-3,3,3-trifluoropropylsilxoane unit.

The organopolysiloxane should preferably be one having in one molecule at least two aliphatic unsaturated groups such as alkenyl group and cycloalkenyl group, particularly vinyl group. The amount of the aliphatic unsaturated groups should preferably be 0.01 to 20 mol%, particularly 0.02 to 10 mol% of all the groups represented by R¹. The unsaturated aliphatic group may bond to the silicon atom at both ends or at middle or at both end and middle of the molecular chain. Preferably, the unsaturated aliphatic group is bonded to the terminal silicon atom.

In the formula (I), "a" should be a positive number from 1.95 to 2.05, preferably from 1.98 to 2.02, and more preferably 1.99 to 2.01.

The organopolysiloxane as component (A) should preferably be one represented by the average compositional formula (I) in which R¹ is a monovalent hydrocarbon group having 1 to 6 carbon atoms, with at least two members thereof being alkenyl groups in one molecule.

The organopolysiloxane as component (A) should preferably be one which has its molecular chain terminated with a triorganosiloxy group, such as trimethylsiloxy group, dimethylphenylsiloxy group, dimethylhydroxysiloxy group, dimethylvinylsiloxy group, methyldivinylsiloxy group, and trivinylsiloxy group.

Preferable examples of the organopolysiloxane include methylvinylpolysiloxane, methylphenylvinylpolysiloxane, and methyltrifluoropropylvinylpolysiloxane.

The organopolysiloxane mentioned above may be obtained by (co)hydrolysis and condensation of at least one of organohalogenosilane, or by ring opening polymerization of cyclic polysiloxane (trimer or tetramer) in the presence of alkaline or acidic catalyst. The resulting product is basically a diorganopolysiloxane having straight chain; a mixture of two or three or more species thereof differing in molecular weight (degree of polymerization) and molecular structure may be used as component (A).

The organopolysiloxane should have a degree of polymerization at least 100, preferably 100 to 100,000, and particularly 3,000 to 20,000. This value is one which is expressed in terms of the weight average molecular weight of polystyrene determined by gel permeation chromatography (GPC).

Component (B) is reinforcing silica having a BET specific surface area larger than 200 m²/g. This reinforcing silica is added to obtain the silicone rubber composition superior in clarity and mechanical strength. It needs to have a BET specific surface area larger than 200 m²/g, preferably at least 250 m²/g, so that the silicone rubber composition incorporated with it excels in clarity. With a BET specific surface area up to 200 m²/g, the silicone rubber composition gives rise to cured products poor in clarity. The BET specific surface area is not specifically restricted in its upper limit; however, it should be up to 500 m²/g, preferably up to 400 m²/g, from the standpoint of handleability.

Silica to be incorporated into silicone rubber compositions is usually fumed silica or precipitated silica. The former is used in the present invention because the latter impairs clarity. Preferable fumed silica is one which has hydrophobic surface treatment with chlorosilane, alkoxysilane, hexamethyldisilazane, particularly with hexamethyldisilazane which improves clarity.

The silicone rubber composition may contain reinforcing silica as component (B) in an amount of 70 to 150 parts by weight, preferably 70 to 120 parts by weight for 100 parts by weight of the organopolysiloxane as component (A). With an amount less than 70 parts by weight, the reinforcing silica is not effective in making the sheet of the silicone rubber compound clear after curing. With an amount more than 150 parts by weight, the silica does not readily disperse into the silicone polymer.

Component (C) is an organohydrogenpolysiloxane having at least two hydrogen atoms (SiH groups) bonded to silicon atoms in one molecule. It may be any known one represented by the average compositional formula (II) below:

R²_{b}H_{c}SiO_{(4-b-c)/2} (II)

wherein R² is a substituted or unsubstituted monovalent hydrocarbon group having 1 to 6 carbon atoms; and b is 0.7 to 2.1 and c is 0.18 to 1.0 such that (b+c) is 0.8 to 3.0.

R² is a substituted or unsubstituted monovalent hydrocarbon group having 1 to 6 carbon atoms, preferably one free of aliphatic unsaturated bonds. For example, it includes: alkyl group such as methyl group, ethyl group, propyl group, butyl group, pentyl group, and hexyl group; unsubstituted monovalent hydrocarbon group such as cyclohexyl group and phenol group; and substituted monovalent hydrocarbon group such as substituted alkyl group, typically 3,3,3-trifluoropropyl group and cyanomethyl group, which is formed from the above monovalent hydrocarbon group by at least partial substitution of its hydrogen atoms by halogen atom or cyano group.

The values of b and c should preferably be 0.8 to 2.0 and 0.2 to 1.0, respectively, such that their sum (b+c) is 1.0 to 2.5.

The organohydrogenpolysiloxane as component (C) may have any molecular structure, such as linear, cyclic, branched, and three-dimensional network. It should preferably be a liquid one at room temperature which has a degree of polymerization in terms of 2 to 300 silicon atoms, particularly 4 to 200 silicon atoms, per molecule. The hydrogen atoms (SiH groups) bonded to silicon atoms may be present at the molecular terminals or the side chains or both. The number of such hydrogen atoms in one molecule should be at least 2 (usually 2 to 300), preferably 3 or more (for example, 3 to 200), and more preferably 4 to 150.

The following are examples of the organohydrogenpolysiloxane as component (C):
1,1,3,3-tetramethyldisiloxane,
1,3,5,7-tetramethylcyclotetrasiloxane,
methylhydrogencyclopolysiloxane,
methylhydrogensiloxane-dimethylsiloxane cyclic copolymer, tris(dimethylhydrogensiloxy)methylsilane,
tris(dimethylhydrogensiloxy)phenylsilane,
methylhydrogenpolysiloxane with both ends blocked by trimethylsiloxy groups,
dimethylsiloxane-methylhydrogensiloxane copolymer with both ends blocked by trimethylsiloxy groups,
dimethylpolysiloxane with both ends blocked by dimethylhydrogensiloxy groups,
dimethylsiloxane-methylhydrogensiloxane copolymer with both ends blocked by dimethylhydrogensiloxy groups,
methylhydrogensiloxane-diphenylsiloxane copolymer with both ends blocked by trimethylsiloxy groups,
methylhydrogensiloxane-diphenylsiloxane-dimethylsiloxane copolymer with both ends blocked by trimethylsiloxy groups, cyclic methylhydrogen polysiloxane,
cyclic methylhydrogensiloxane-dimethylsiloxane copolymer, cyclic methylhydrogensiloxane-diphenylsiloxane-dimethylsiloxane copolymer,
copolymer composed of (CH₃)₂HSiO_{1/2} units, and SiO_{4/2} units, copolymer composed of (CH₃)₂HSiO_{1/2} units, SiO_{4/2} units, and (C₆H₅)SiO_{3/2} units, and
those compounds shown above in which methyl groups are partially or entirely replaced by alkyl groups such as ethyl group and propyl group, or aryl groups such as phenyl group.

The amount of organohydrogenpolysiloxane as component (C) should be 0.1 to 30 parts by weight, preferably 0.1 to 10 parts by weight, more preferably 0.3 to 10 parts by weight, for 100 parts by weight of organopolysiloxane as component (A).

The organohydrogenpolysiloxane as component (C) should be added in such an amount that the molar ratio of hydrogen atoms (that is, SiH groups) bonded to silicon atoms in component (C) to alkenyl groups bonded to silicon atoms in component (A) is from 0.5 to 5 mol/mol, preferably from 0.8 to 4 mol/mol, more preferably from 1 to 3 mol/mol.

The catalyst for hydrosilylizing reaction as component (D) may be any known one, which includes: platinum catalysts such as platinum black, platinic chloride, chloroplatinic acid, reaction product of chloroplatinic acid and monohydric alcohol, complex composed of chloroplatinic acid and olefins, and platinum bisacetoacetate; palladium catalyst; and rhodium catalyst.

The catalyst for hydrosilylizing reaction as component (D) should be added in a catalytic amount, which is usually 0.5 to 1,000 ppm, preferably 1 to 200 ppm in terms of platinum, based on the amount of component (A).

The silicone rubber composition composed of components (A) to (D) may optionally contain flame retardant and coloring agent in an amount not harmful to the object of the present invention.

The silicone rubber composition may be obtained from the above components by mixing with a two-roll mill, kneader, or Banbury mixer.

The silicone rubber composition may be molded by any way such as press molding, extrusion molding, and calendering, without specific restrictions.

The silicone rubber composition may be cured under any condition without specific restrictions. Curing may be accomplished generally by heating at 80 to 300°C, preferably, 100 to 250°C for five seconds to an hour, especially for 30 seconds to 30 minutes. This curing step may be followed by post-curing at 100 to 200°C for 10 minutes to 10 hours.

The cured product of the silicone rubber composition should have optical properties specified below. A cured specimen in the form of 2-mm thick sheet should have a total light transmittance at least 90% at wavelengths of 0.35 to 1.15 µm, which cover the region of spectral sensitivity of crystalline silicon. Specifically, the total light transmittance is at least 90% and higher determined by Haze Computer HGM-2 of direct reading type (made by Suga Test Instruments Co., Ltd.). With a total light transmittance lower than 90%, the cured sheet of the silicone rubber composition prevents the incident light from reaching its far end due to diffusion. Moreover, a cured specimen in the form of 2-mm thick sheet should have a haze value up to 10, particularly up to 8, as determined by Haze Computer HGM-2 of direct reading type (made by Suga Test Instruments Co., Ltd.). With a haze value higher than 10, the cured sheet of the silicone rubber composition prevents the incident light from reaching its far end due to diffusion.

The following is a description of the light control sheet for solar cell modules according to the present invention. It is a sheet formed by curing from a silicone rubber composition which, when it is 2 mm in thickness, exhibits a light transmittance at least 90% for light whose wavelength is 0.35 to 1.15 µm. It is so formed as to have a specific cross section which remains constant in one direction in order that the solar cell module of the present invention efficiently catches direct incident sunlight even though the sun changes in southing height from one season to another.

An adequate cross section should be determined in consideration of the fact that the southing height fluctuates between +23° (at summer solstice) and -23° (at winter solstice), measured from that at spring equinox and autumn equinox. The light control sheet employed in the solar cell module shown in Fig. 1 has a cross section which permits the direct incident sunlight with an incident angle of 50° to reach the receiving surface of the solar cell while keeping the function to reduce the shadow loss due to the finger electrodes or bus bar electrodes. This has been confirmed by using software (Light Tools) for geometric optics.

The solar cell module according to the present invention does not essentially need any tracking system to make its receiving plane face the sun. Instead, it has the light-transmitting elastomer member which ensures high conversion efficiency and high long-term durability during outdoor exposure. Thus, it is suitable for installation in a large solar cell power station which is expected to solve the global environment issue.

The frame member 7 mentioned above should preferably be made of aluminum alloy or stainless steel, which is light in weight, superior in weather resistance, and strong enough to withstand shock, wind pressure, and snowfall. The frame member 7 formed from these materials encircles and fastens with screws the outer periphery of the structure held between the panels 1 and 5.

The solar cell module according to the present invention is constructed such that the solar cell element is fitted under pressure by the light-transmitting elastomer member 2 having rubbery resilience. The pressure applied to the solar cell element should be at least 0.01 MPa and up to 5.0 MPa, preferably at least 0.05 MPa and up to 2.0 MPa. With a pressure lower than 0.01 MPa, the solar cell element will not be firmly fixed, will be unable to capture sunlight entirely, or will be unable to dissipate heat from its back side. Conversely, with a pressure higher than 5.0 MPa, the solar cell element will suffer distortion due to difference in linear expansion coefficient at the time of temperature change; this results in deformation of the optical sheet made of light-transmitting elastomer, which in turn deteriorates the refracting action for sunlight. In addition, the thickness of the solar cell element up to 120 µm is liable to break easily.

The solar cell module according to the present invention is constructed such that the transparent material panel 1 through which the sunlight enters, and the heat-conducting material panel 5 opposite to the panel 1 have their peripheral edges fixed together with the spacer 9 interposed between them. The spacer 9 keeps the transparent material panel 1 through which the sunlight enters and the heat-conducting material panel 5 a certain distance apart from each other, and also controls the pressure applied to the solar cell element 3 by the light-transmitting elastomer member 2. It may be formed from metal such as aluminum, or hard resin.

The solar cell module according to the present invention may have the heat-conducting elastomer layer 4 which is interposed between the heat-conducting material panel 5 and the solar cell element 3. The layer 4 may be a separately formed sheet or a layer formed by coating in situ. It relieves and absorbs strain due to difference in linear expansion coefficient between the heat-conducting material panel 5 and the solar cell element 3, and it also improves adhesion between them, thereby facilitating efficient heat dissipation.

The heat-conducting elastomer layer 4 should preferably be formed from cured silicone rubber having a thermal conductivity at least 0.2 W/m·K and up to 5 W/m·K, particularly 0.5 to 5 W/m·K (measured according to ASTM E1530). With a thermal conductivity lower than 0.2 W/m·K, the heat-conducting elastomer layer 4 needs a higher temperature or a longer time for heat-bonding the panel 5 of heat-conducting material and the solar cell element 3 together under pressure, resulting in poor efficiency. With a thermal conductivity higher than 5 W/m·K, the heat-conducting elastomer layer 4 is too hard to be processed into sheet form easily and prevents uniform bonding to the solar cell element.

The heat-conducting elastomer layer 4 should preferably have a thickness at least 200 µm and up to 700 µm, particularly at least 300 µm and up to 500 µm. With a thickness smaller than 200 µm, the heat-conducting elastomer layer 4 does not permit rapid movement of heat from the solar cell element to the heat-conducting elastomer layer 4 and hence cannot prevent the solar cell element from increasing in temperature. With a thickness larger than 700 µm, the heat-conducting elastomer layer 4 prevents rapid movement of heat from the heat-conducting elastomer layer 4 to the heat-conducting material.

The heat-conducting elastomer layer 4 mentioned above should be made of a curable organopolysiloxane (100 parts by weight) incorporated with at least one filler selected from the group consisting of carbon, metal, metal oxide, metal nitride and metal carbide (10 to 1,600 parts by weight). Examples of the filler include silver powder, copper powder, iron powder, nickel powder, and aluminum powder as metal, zinc oxide, magnesium oxide, aluminum oxide, silicon oxide, and iron oxide as metal oxide, boron nitride, aluminum nitride, and silicon nitride as metal nitride, and silicon carbide and boron carbide as metal carbide.

The heat-conducting elastomer composition mentioned above may optionally be incorporated with additives such as color pigment, heat resistance improver, flame retardance improver, and acid acceptor or dispersing agents such as alkoxysilane, diphenylsilanediol, carbonfunctional silane, and silanol group-containing siloxane.

The heat-conducting elastomer composition may be prepared from the above components by uniform mixing with a mixing machine such as two-roll mill, Banbury mixer, kneader, and planetary mixer. The resulting mixture may optionally undergo heat treatment at least 100°C.

The heat-conducting elastomer composition is made into a rubbery elastic body by curing the curable organopolysiloxane with a curing agent. The curing agent may be one which is commonly used for curing silicone rubber compositions. The curing agent is selected from an organic peroxide such as di-t-butylperoxide, 2,5-dimethyl-2,5-di(t-butylperoxy)hexane, and dicumylperoxide which are suitable for radical reaction, a combination composed of a platinum group catalyst and an organohydrogenpolysiloxane having at least two hydrogen atoms bonded to silicon atoms (SiH groups) in one molecule as a curing agent for an addition reaction when the curable organopolysiloxane has at least two alkenyl groups, and an organosilicon compound having at least two hydrolyzable groups such as alkoxy group, acetoxy group, ketoxime group and propenoxy group as a curing agent for a condensation reaction when the curable organopolysiloxane has at least two silanol groups or hydrolyzable groups. The same amount of the above-mentioned compounds may be added as in the usual case for curing silicone rubber compositions.

The heat-conducting elastomer composition may be either millable silicone rubber composition or liquid silicone rubber composition. The one capable of curing by addition reaction or organic peroxide is desirable from the standpoint of workability and moldability.

The heat-conducting elastomer composition mentioned above should be made into the heat-conducting elastomer layer by curing.

### EXAMPLES

The present invention will be described in more detail with reference to the following Examples, which are not intended to restrict the scope thereof. In the following Examples, "parts" means "parts by weight."

### Reference Example 1

### Preparation of light-transmitting elastomer member

A compound was prepared from the following components by mixing with the help of a kneader and ensuing heat treatment at 170°C for two hours.
100 parts of organopolysiloxane having an average molecular weight of about 6,000, composed of dimethylsiloxane units (99.425 mol%), methylvinylsiloxane units (0.50 mol%), and dimethylvinylsiloxane units (0.025 mol%)
70 parts of silica having a BET specific surface area of 300 m²/g ("Aerosil 300" from Nippon Aerosil Co., Ltd.)
16 parts of hexamethyldisilazane as a dispersing agent
4 parts of water

The resulting compound (100 parts) was uniformly mixed with an addition crosslinking agent, which is a mixture prepared by mixing uniformly with a two-roll mixer from 0.5 parts of C-25A (platinum catalyst) and 2.0 parts of C-25B (organohydrogenpolysiloxane), both from Shin-Etsu Chemical Co., Ltd. The resulting mixture (compound) was press molded into a sheet-like object consisting of a number of small pieces joined together, each having a semielliptic cross section. The press molding was carried out at 120°C and 70 kgf/cm², followed by press curing for ten minutes and post curing at 200°C for four hours. Thus there was obtained a sheet sample having a thickness of 1.0 mm (excluding the joining parts).

### Example 1

### Preparation of solar cell module

A solar cell module was prepared as follows which contains as one component the light-transmitting elastomer member prepared in Reference Example 1 mentioned above.

The light-transmitting elastomer member and a solar cell element were provided on the light incidence plane of a white tempered glass sheet (3.5 mm thick) such that the light incidence plane was brought into contact with the light-transmitting elastomer member. The solar cell element was provided with finger electrodes at the joining parts of the light-transmitting elastomer member. A heat-conducting elastomer was arranged on that side of the solar cell element which is opposite to the light incidence plane. The heat-conducting elastomer is a heat-dissipating silicone sheet "TC-20A" (form Shin-Etsu Chemical Co., Ltd.) having a thickness of 0.2 mm and a thermal conductivity of 1.1 W/m·K. The white tempered glass sheet was provided with a spacer of aluminum alloy on that side to which the solar cell element was attached. This spacer was preferably bonded to the white tempered glass sheet with a silicone rubber or butyl rubber. Another white tempered glass sheet was bonded in such a way that the two white tempered glass sheets hold the space between them. The periphery of the spacer was sealed with silicone rubber or butyl rubber. The two white tempered glass sheets were fixed in place by a rectangular C-shaped frame of aluminum alloy so that the heat-dissipating silicone sheet receives a pressure of about 0.5 MPa. Thus there was obtained the silicon solar cell module as desired. Incidentally, the electrodes are extended from between the two glass sheets as in the case of double-sided module in which both the light incidence plane and the opposite plane are glass sheets and the structure of opposing glass sheets is used.

The solar cell module thus obtained achieved the reduction of shadow loss due to finger electrodes.

## Claims

1. A solar cell module composed of a panel of transparent material that transmits sunlight, a panel of heat-conducting material arranged opposite to the sunlight incidence side, a light transmitting elastomer member, and a solar cell element, said light transmitting elastomer member and said solar cell element being interposed between said panel of transparent material and said panel of heat-conducting material, with said light transmitting elastomer member being disposed on the sunlight incidence side, in such a way that said light-transmitting elastomer member presses said solar cell element against said panel of heat-conducting material, wherein said light transmitting elastomer member includes a plurality of small pieces joined together, at least whose light incidence plane has a semicircular cross section, semielliptic cross section, or half-racetrack-like cross section with round sides, and said small pieces are formed such that the finger electrodes and/or bus bar electrodes of said solar cell element are arranged at the joining parts of said small pieces so that said light transmitting elastomer member alters the optical path of the direct incident light by the refractive action of the light transmitting elastomer, thereby allowing the finger electrodes and/or bus bar electrodes of said solar cell element to be placed in the region where there is less incident light than the region where there is direct incident light not affected by refractive action.

2. The solar cell module of claim 1, wherein the panel of heat conductive material and the solar cell element are arranged with heat conductive elastomer layer interposed between them.

3. The solar cell module of claim 2, wherein the heat conductive elastomer layer is formed from heat-conductive silicone rubber having a thermal conductivity at least 0.2 W/m·K and up to 5 W/m·K.

4. The solar cell module of any one of claims 1 to 3, wherein the panel of transparent material and the panel of heat conductive material are arranged such that a spacer member is placed at the end of the space between the panels.

5. The solar cell module of any one of claims 1 to 4, wherein the panel of transparent material and the panel of heat conductive material are fixed together by a frame member which is spanned between the panels' peripheries.

6. The solar cell module of any one of claims 1 to 5, wherein the panel of heat conductive material is formed from glass, synthetic resin, or metal, or composite material thereof.

7. The solar cell module of any one of claims 1 to 6, wherein the solar cell element is formed from silicon material.

8. The solar cell module of any one of claims 1 to 7, wherein the light-transmitting elastomer member is a cured product of silicone rubber composition.

9. A light control sheet for solar cell modules which is arranged on the light incidence side of a solar cell element having finger electrodes and bus bar electrodes and which disperses the direct incident light entering the finger electrodes and/or bus bar electrodes toward the surrounding thereof, wherein the finger electrodes and/or bus bar electrodes of said solar cell element are arranged at joining parts of a plurality of small pieces of elastomer joined together, at least whose light incidence plane has a semicircular cross section, semielliptic cross section, or half-racetrack-like cross section with round sides.
